# EUROPEAN PATENT APPLICATION

(11) **EP 1 160 840 A2**
(43) Date of publication of application: **05.12.2001**
(21) Application number: 01810403.4
(22) Date of filing: 25.04.2001
(51) Int. Cl.: H01L 21/00

(54) **Container for conveying flat objects**

(30) Priority: 29.05.2000 CH 10802000
(71) Applicant: Middlesex Industries S.A., 6928 Manno (CH)
(72) Inventor: Horn, George W., 6614 Brissago (CH)
(74) Representative: Fiammenghi-Domenighetti, Delfina

(57) **Abstract**

A description is given of a container (1) for sliding on structural track elements (5) forming part of a system for the conveyance of flat objects (11p) such as discs of silicone and the like, comprising:
a) a body (2) in the form of a box that is open on at least its upper side (2s) and forms a volume (2v) having two lateral walls (2g) parallel to the direction of motion of the container (1);
b) two racks (3) formed on the said lateral walls (2g) inside the said volume (2v) to form a plurality of parallel opposing slots (3p) oriented approximately vertically, each slot being able to hold one of the said flat objects (lie); and
c) one or more runners (4) underneath the said body (2) for sliding on the said structural track elements (5) when the box (1) is moved through the controlled-atmosphere system;
characterized in that each pair of opposing slots is formed in two opposing pairs of upper (3s) and lower (3i) pockets mounted on the lateral walls (2g), and in that the said body (2), the said upper (3s) and lower (3i) pockets contained in its volume (2v) and the said two or more runners (4) are all independent pieces assembled together to form the box (1) and made from materials having differing physical and chemical characteristics.

## Description

The present invention relates to the technological sector of systems used for moving electronic components or discs (wafers) of silicone through various stations situated in controlled-or non controlled-atmosphere environments, i.e. environments in which the air may even be filtered and conditioned to extremely high levels in order to ensure that no dust or other impurities are deposited on the pieces undergoing treatment, which would unacceptably compromise the accuracy and the very objectives of the processes and treatments applied to them.

More specifically, the invention relates to a container that runs on structural track elements forming part of a system of the type described, and that contains, in a special rack, a number of objects of flat shape such as e.g. silicone discs (or wafers) that have to undergo a number of different processes as they are conveyed between the various stations of the system.

This kind of container, which is known to those skilled in the art, takes the form of an open-topped box containing the said rack, which consists of a number of pairs of opposing parallel slots arranged approximately vertically and formed in those walls of the container which are parallel to the direction of its motion, in which slots the abovementioned silicone discs are placed with their lower edges resting on curved parts of the slots that run towards the centre of the container.

The container, as already mentioned, slides on runners along the surfaces of tracks which are usually made in the form of idle wheels made of high-density polyurethane.

Existing containers are produced, usually by a moulding process, as a monolithic body made of a plastic material (such as a synthetic resin "filled" or otherwise with reinforcing fibres). The said slots, moreover, are formed along the full length of the said two lateral walls of the container.

The problem then arises that the single material selected for producing a container is a material whose characteristics are perfectly suited to the functional necessities of one of the parts of the container described above, but not for the others.

For example, the aforesaid slots of the racks of a container must be very resistant to the wear caused by contact with the lower edges of the objects carried, whereas the membranes that separate them must not generate vibrations but instead must damp out the impacts to which they are subjected by the flat objects contained in the container as they travel about.

The runners described above, on the other hand, must have the lowest possible coefficient of friction in contact with the material of the said tracks.

Moreover, as far as the remaining parts having purely structural functions are concerned, the container as a whole must exhibit characteristics such as to allow it to be produced with great dimensional accuracy, with very small margins of tolerance for each dimension.

As will be readily appreciated, it is physically impossible for a monolithic container made from only one material to simultaneously possess all the characteristics enumerated above, and the result is that it is necessarily suited to one of the said functions and less suited to the others, or it is "sufficiently", but not satisfactorily suited to all the functions, with repercussions on the precision and effect of the various processing stages of a system, on its speed and efficiency.

The inventor of this invention felt that the problems explained above could be avoided if a container of the type in question were made not in one piece from a single material but rather in several parts from appropriately selected materials assembled together, and its said slots were made by opposing pairs of pockets attached above and below to the lateral walls that define the internal space of the container.

In this way the best material can be selected for each part so that each part is able to perform its specific function in the best possible way.

The inventor has therefore devised a container as described in the preamble of the attached Claim 1, characterized by the characterizing part of the same claim.

A more detailed description will now be given of a preferred example of an embodiment of the container according to the invention, but this example is not to be understood as binding or limiting with respect to other embodiments obtainable by a person skilled in the art when following the teachings of the abovementioned Claim 1.

In the said description reference will also be made to the attached drawings, which show:
- in Figure 1 a perspective view of the whole of the said preferred example of an embodiment of a container according to the invention containing the flat objects (silicone discs);
- in Figure 2 an exploded perspective view of the same container as in Figure 1; and
- in Figure 3 the shape of the outline of the frontal view of a slot housing a flat object when the container is rotated by 90°.

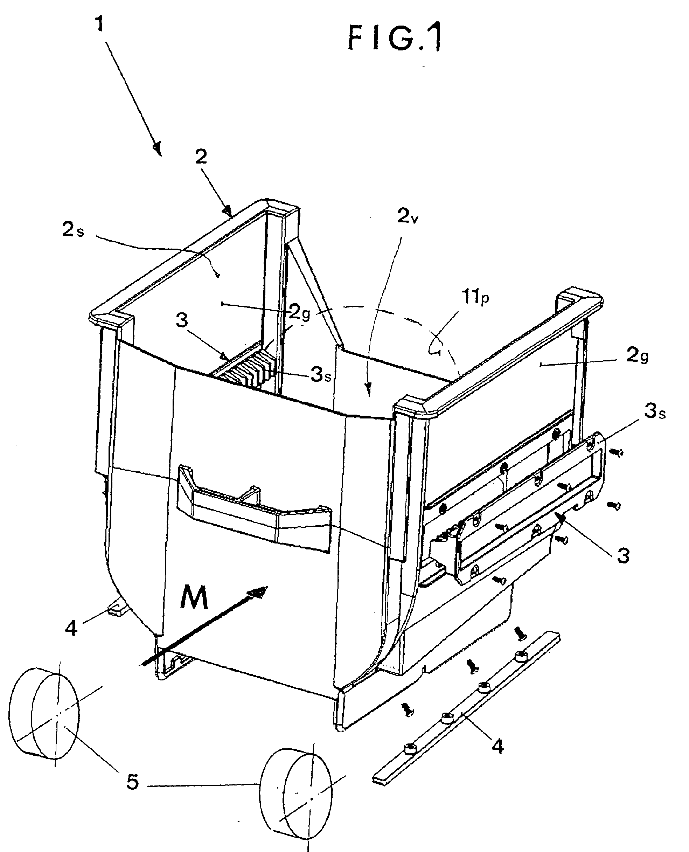

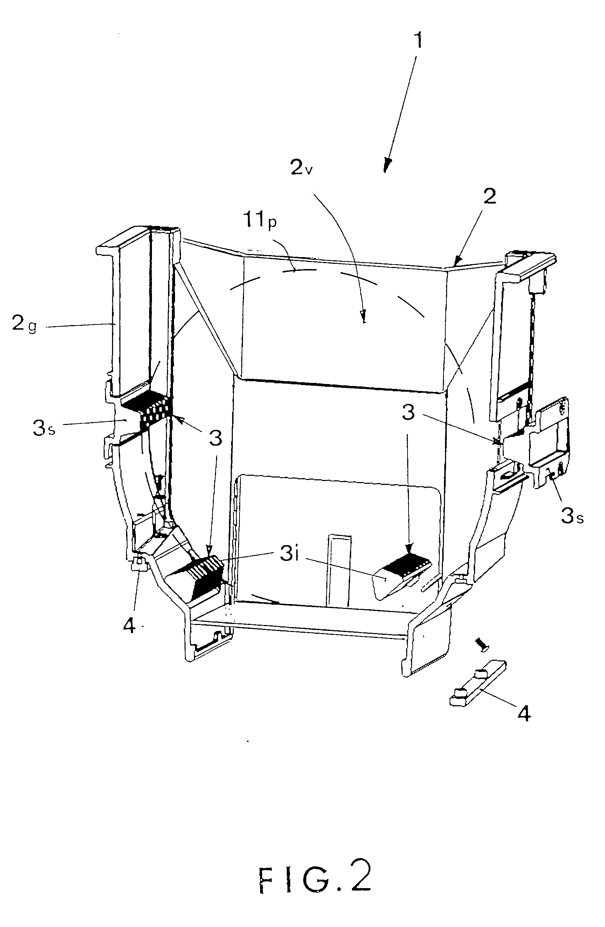

When viewing Figures 1 and 2, it can be seen that the container 1 of the invention consists, as Figure 2 shows in more detail, of a body 2 in the form of a box that is open on its upper side 2s, that forms a volume 2v, with lateral walls 2g parallel to the direction of motion of the said container 1. This body 2, for the reasons of dimensional accuracy already discussed, is preferably made of polycarbonate.

Fixed inside this volume 2v, on its lateral walls 2g, are two pairs of pockets 3i, 3s, forming a pair of opposed racks 3 that possess a plurality of parallel slots 3p oriented approximately vertically and separated from one another by membrane walls 3d. To prevent vibrations and damp out impacts, the upper pockets 3s may e.g. be made from a material suitable for these purposes, such as polysulphone for example.

However, the lower pockets 3i, which support the lower edges of the flat objects 11e contained in the slots 3p, are made of a material extremely resistant to wear by friction, such as PEEK (polyetereterketon) for example. Each flat object 11p is housed in two opposing pairs of upper 3s and lower 3i pockets mounted on the said lateral walls 2g in such a way that they cover only limited portions of these.

Lastly, the said one or more runners 4 (two in the figures) are made of a material that has a low coefficient of friction with respect to the material from which the structural track elements 5 are constructed. If these structural elements (which are usually idle wheels) are made from high-density polyurethane, the abovementioned runners 4 can advantageously be made from polybutylene, for instance.

It is felt unnecessary to describe in detail the systems (such as interlocking means, by adhesives with threaded means, etc.) that may be used for assembling together the various parts that go to make up a container according to the invention, as such systems are very simple and are well known to all ordinarily skilled persons working in the field.

During its handling, a container 1 of the type described is only tilted 90° onto a vertical plane so that the flat objects 11p that it contains are laid parallel with the ground, with its open top side 2s facing a unit that is to perform an operation on the objects. The racks, according to the prior art, have slots of U-shaped cross section, with both sides inclined relative to the lateral walls of the container in order to assist engagement of the flat objects 11p when they are inserted into the container.

The abovementioned cross-sectional shape unfortunately causes problems, because when the flat objects 11p are laid parallel with the ground, their lateral edges rest on two inclined segments and, because of the play necessarily existing between the slots and the flat objects, and because of the vibrations and displacement to which they are necessarily subject in the course of handling, develop a random orientation relative to the ground, that is "approximately" parallel, but not "exactly" parallel to it.

This causes complications and a loss of time while each object is being gripped prior to each individual operation and/or process.

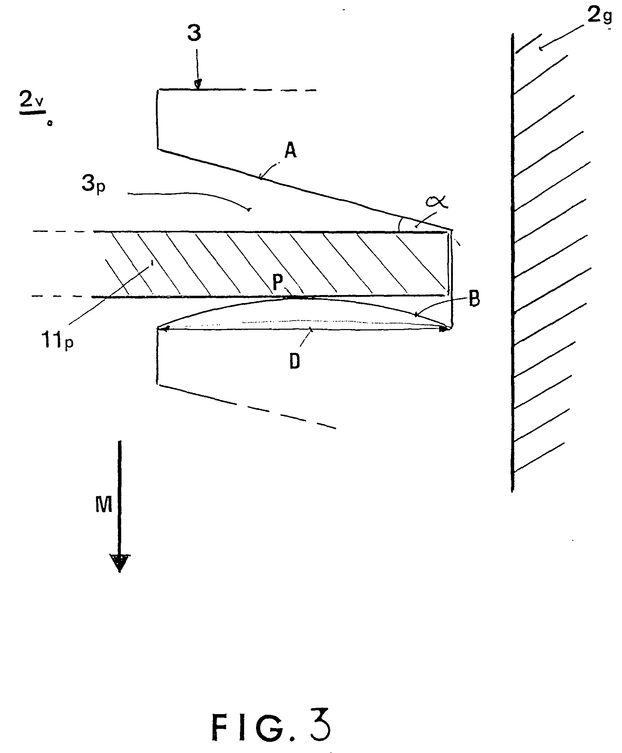

In order to avoid the abovementioned problems, the inventor has devised a special type of slot 3p as regards the shape of its longitudinal section: the profile of this section is essentially a U with its open side towards the centre of the said volume 2v of the container 1, with its side A (see Figure 3), which is downstream with reference to the direction of the container motion (arrow M), oriented at right angles to the lateral wall 2g.

Consequently when the container 1 is rotated through 90°, as already explained, the flat objects 11p contained inside it actually arrange themselves precisely in a position parallel to the ground, as their lateral edges necessarily rest on the two sides A of the abovementioned U of two mutually opposing slots 3p fixed to the two opposite lateral walls 2g forming the volume 2v of the container 1.

In order to make the support of the said lateral edges of a flat object 11p still more precise and reliable, the inventor suggests forming the said downstream side A of each slot with a slightly convex profile to ensure that an object 11p rests only on one linear segment S thereof, perpendicular to the lateral wall 2g.

To obtain this result several different forms of profile are possible for the side A. The inventor suggests one in particular, which is that shown in Figure 3, where the side A of the U section in question has the profile of an arc of a circle subtended by a chord D parallel to the lateral wall 2g.

With this configuration each lateral edge of an object 11p housed in a pair of slots 3p formed by two pockets 3i, 3s rest via only one linear segment S of the profile of each pocket, and on the two pairs of pockets which contain it via four such segments located at exactly the same distance from the ground, this distance depending only on the accuracy with which the slots have been made.

A container 1 constructed in accordance with the invention consequently provides the result of optimizing all its functional characteristics by means of basic technology that is easily put into effect, and thus achieves all the results which the inventor set out to obtain.

## Claims

1. Container (1) for sliding on structural track elements (5) forming part of a system for the conveyance of flat objects (11p) such as discs of silicone and the like, comprising:
a) a body (2) in the form of a box that is open on at least its upper side (2s) and forms a volume (2v) having two lateral walls (2g) parallel to the direction of motion of the container (1);
b) two racks (3) formed on the said lateral walls (2g) inside the said volume (2v) to form a plurality of parallel opposing slots (3p) oriented approximately vertically, each slot being able to hold one of the said flat objects (lie); and
c) one or more runners (4) underneath the said body (2) for sliding on the said structural track elements (5) when the box (1) is moved through the controlled-atmosphere system;
**characterized in that** each pair of opposing slots is formed in two opposing pairs of upper (3s) and lower (3i) pockets mounted on the lateral walls (2g), and **in that** the said body (2) containing in its volume (2v) the said upper (3s) and lower (3i) pockets and the said two or more runners (4) are all independent pieces assembled together to form the box (1) and made from materials having differing physical and chemical characteristics.

2. Container according to Claim 1, in which the said body (2) is made of polycarbonate.

3. Container according to one of the preceding claims, in which the said lower pockets (3i) forming the said rack (3) are made of PEEK (polyether ether ketone).

4. Container according to one of the preceding claims, in which the said upper pockets (3, 5) of the slots forming the aforesaid rack (3) are made of polysulphone.

5. Container according to one of the preceding claims in which the said one or more runners (4) are made from PBT (polybutylene).

6. Container according to one of the preceding claims, in which the said parallel cavities (3p) formed within each of the two upper (3s) and lower (3i) pockets have a cross section that is essentially a U with its open side towards the centre of the said volume (2v), with the side (A), which is downstream with reference to the direction of motion (M) of the container (1), oriented at right angles to the lateral wall (2g).

7. Container according to Claim 6, in which the abovementioned side (A) of the said U oriented at right angles has a convex profile to ensure that the flat object (11p) which it contains rests on it on only via one segment (S).

8. Container according to Claim 7, in which the said side (A) has the profile of an arc of a circle (C) subtended by a chord (D) parallel to the lateral wall (2g).
